(19) Europäisches Patentamt
European Patent Office
Office européen des brevets

(11) **EP 4 246 658 A1**

(12) **EUROPEAN PATENT APPLICATION**

(43) Date of publication:
**20.09.2023 Bulletin 2023/38**

(21) Application number: **23151212.0**

(22) Date of filing: **11.01.2023**

(51) International Patent Classification (IPC):
***H01M 10/42*** (2006.01)      ***H01M 10/48*** (2006.01)

(52) Cooperative Patent Classification (CPC):
**H01M 10/4285;** H01M 10/482

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.03.2022 JP 2022041022**

(71) Applicant: **TOYOTA JIDOSHA KABUSHIKI KAISHA**
**Aichi-Ken 471-8571 (JP)**

(72) Inventor: **KOMIYAMA, Keita**
**TOYOTA-SHI, AICHI-KEN, 471-8571 (JP)**

(74) Representative: **Cabinet Beau de Loménie**
**158, rue de l'Université**
**75340 Paris Cedex 07 (FR)**

(54) **BATTERY MANAGEMENT SYSTEM**

(57)      A battery management system includes an arithmetic processing unit that selects a replacement battery from among a plurality of candidate batteries, to replace an installed battery that is installed in equipment. The arithmetic processing unit calculates an assumed greatest current rate of each of the candidate batteries when used in the equipment, from current rate history of the installed battery and capacity of the candidate battery taking into consideration an amount of deterioration of the candidate battery. The arithmetic processing unit selects a battery of which the assumed greatest current rate of each of the candidate batteries that is calculated is no greater than a predetermined current rate, from among the candidate batteries as the replacement battery.

FIG. 4

**Description**

BACKGROUND OF THE INVENTION

1. Field of the Invention

The present disclosure relates to a battery management system.

2. Description of Related Art

Various studies have been conducted with regard to battery management systems relating to replacement of batteries.

Japanese Unexamined Patent Application Publication No. 2016-139572 (JP 2016-139572 A) discloses a secondary battery management system in which secondary batteries can be replaced, taking into consideration a temperature load.

SUMMARY OF THE INVENTION

When batteries are used at a predetermined current rate (current C rate) or higher, a resistance value of the battery rises markedly. Accordingly, when replacing batteries, simply taking the temperature load into consideration may not be sufficient to replace the battery with one that is optimal for the user, depending on the operating environment of the user.

The present disclosure provides a battery management system that enables a user replacing a battery to perform replacement with a battery that is optimal for the user.

The battery management system according to the present disclosure, includes an arithmetic processing unit that selects a replacement battery from among a plurality of candidate batteries, to replace an installed battery that is installed in equipment. The arithmetic processing unit calculates an assumed greatest current rate of each of the candidate batteries when used in the equipment, from current rate history of the installed battery and capacity of the candidate battery taking into consideration an amount of deterioration of the candidate battery. The arithmetic processing unit selects a battery of which the assumed greatest current rate that is calculated is no greater than a predetermined current rate, from among the candidate batteries as the replacement battery.

In the battery management system according to the present disclosure, the arithmetic processing unit may calculate the assumed greatest current rate of each of the candidate batteries when used in the equipment, from the current rate history of the installed battery, the capacity of the candidate battery taking into consideration an amount of deterioration of the candidate battery calculated based on usage history of the installed battery, and an assumed period of use of the candidate battery.

The present disclosure can provide a battery management system that enables a user replacing a battery to perform replacement with a battery that is optimal for the user.

BRIEF DESCRIPTION OF THE DRAWINGS

Features, advantages, and technical and industrial significance of exemplary embodiments of the invention will be described below with reference to the accompanying drawings, in which like signs denote like elements, and wherein:

FIG. 1 is a graph showing an example of a relation between current rate (current C rate) and resistance value in an all-solid-state battery having a negative electrode using lithium titanate (LTO) as a negative electrode active material;
FIG. 2 is a graph showing a relation between temperature T and deterioration rate of a battery;
FIG. 3 is a diagram showing an example of electricity passage time at each temperature at a predetermined SOC of the battery; and
FIG. 4 is a flowchart showing an example of procedures of a selection method for a replacement battery, executed by a battery management system according to the present disclosure.

DETAILED DESCRIPTION OF EMBODIMENTS

An embodiment according to the present disclosure is described below. Note that matters other than those specifically mentioned in the present specification and necessary to carry out the present disclosure (e.g., a general configuration and manufacturing process of a battery management system that do not characterize the present disclosure) can be comprehended based on the related art in this field. The present disclosure may be carried out based on the content disclosed in the present specification and the common general technical knowledge in this field.

The battery management system according to the present disclosure is a battery management system that selects a replacement battery from among a plurality of candidate batteries, to replace an installed battery that is installed in equipment. In the battery management system, an assumed greatest current rate of each of the candidate batteries when used in the equipment is calculated, from current rate history of the installed battery and capacity of the candidate battery taking into consideration an amount of deterioration of the candidate battery. In the battery management system, a battery of which the assumed greatest current rate that is calculated is no greater than a predetermined current rate, is selected from among the candidate batteries as the replacement battery.

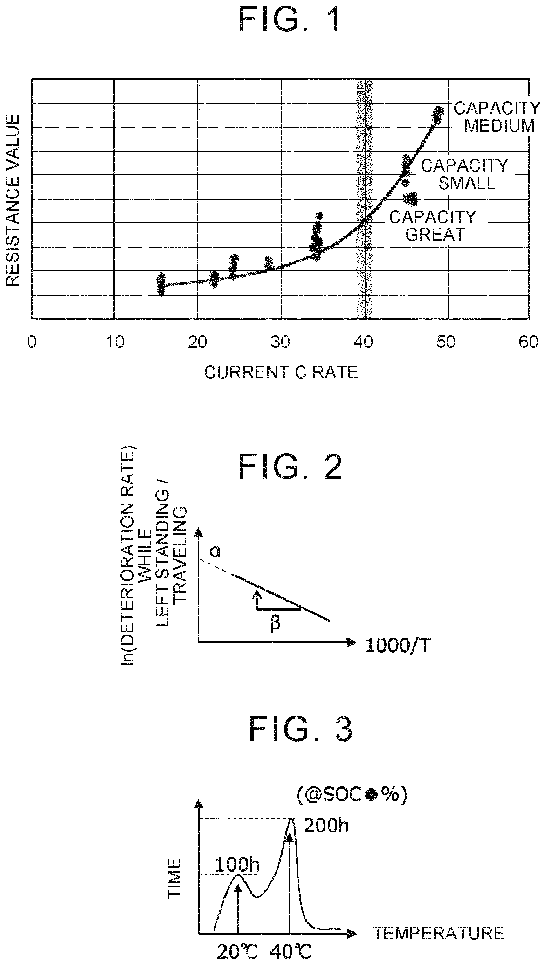

FIG. 1 is a graph showing an example of a relation between current rate (current C rate) and resistance value in an all-solid-state battery having a negative electrode using lithium titanate (LTO) as a negative electrode active material. As shown in FIG. 1, in a case of an all-solid-state battery with an LTO negative electrode, the resistance value suddenly rises beyond 40C. Regardless of the capacity value of the all-solid-state battery, the resistance value rises sharply after around 40C. When a user selects a battery to replace without taking the current rate of the battery to be used into consideration, deterioration in performance of the replaced battery may be accelerated. In the present disclosure, the rate distribution regarding the degree of the current rate at which the installed battery is being used is calculated based on usage history regarding the current rate of the installed battery that is the object of replacement, when the installed battery and the replacement battery are to be exchanged. Thus, the battery usage environment of the user is taken into consideration. Also, the assumed greatest current rate of the candidate battery when used in the equipment is calculated based on the capacity of the candidate battery taking into consideration the amount of deterioration (deterioration state) of the candidate battery, which is a candidate for the replacement battery. A battery of which the assumed greatest current rate is no greater than the predetermined current rate is selected as the replacement battery. Thus, the installed battery can be replaced with a battery that is optimal for the user. As a result, performance deterioration of the battery following replacement can be suppressed.

Usage History

In the present disclosure, the usage history of the battery may be current rate history, temperature history, state of charge (SOC) history, electricity passage history, and so forth, of the battery. The definitions of current rate history, temperature history, SOC history, and electricity passage history, are as follows. The current rate history is history of current rates at which the battery has been used up to the present (point in time of replacement). The temperature history is history (how long the battery has been exposed to each temperature) up to the present (point in time of replacement). The SOC history is SOC history of the battery (how long the battery stayed at each SOC) up to the present (point in time of replacement). The electricity passage history is history of flow of current of the battery (how long current flowed at each current value) up to the present (point in time of replacement). In the present disclosure, the SOC value indicates the proportion of charge as to the capacity for fully charging the battery. When fully charged, the SOC is 100%.

Assumed Greatest Current Rate

In the present disclosure, the assumed greatest current rate of the candidate battery when used in equipment is calculated from the current rate history of the installed battery and the capacity of the candidate battery taking into consideration the amount of deterioration of the candidate battery. The current rate history may be extracted from the usage history of the battery. The capacity of the candidate battery taking into consideration the amount of deterioration of the candidate battery may be, for example, the present capacity of the candidate battery, or the assumed capacity that is assumed regarding when the candidate battery is used in equipment. The present capacity of a candidate battery may be calculated by, for example, first calculating the amount of deterioration of the candidate battery, and then correcting the initial capacity of the candidate battery in accordance with the amount of deterioration of the candidate battery. The amount of deterioration of the candidate battery may be, for example, the present amount of deterioration of the candidate battery, the assumed amount of deterioration that is assumed regarding when the candidate battery is used in equipment, or an amount of deterioration that includes both thereof. The amount of deterioration of the candidate battery may be calculated from the usage history of the installed battery alone, from the usage history of the candidate battery alone, or from the usage history of both the installed battery and the candidate battery. The assumed amount of deterioration of the candidate battery is the amount of deterioration assumed when the candidate battery is installed in equipment, and may be calculated from the usage history of the installed battery, or may be calculated taking an assumed period of use into consideration, as necessary. The assumed capacity of the candidate battery may be calculated from the assumed amount of deterioration of the candidate battery. The assumed greatest current rate may be calculated by calculating the greatest current value from the current rate history, and calculating the assumed greatest current rate from this greatest current value and the capacity of the candidate battery taking the amount of deterioration of the candidate battery into consideration.

In the present disclosure, the assumed greatest current rate of the candidate battery when used in the equipment may be calculated from the current rate history of the installed battery, the capacity of the candidate battery taking into consideration the amount of deterioration of the candidate battery calculated based on the usage history of the installed battery, and the assumed period of use of the candidate battery. In this case, the assumed greatest current rate is calculated based on the reduction in capacity of the candidate battery due to the amount of deterioration, taking into account the assumed period of use of the candidate battery. The amount of deterioration that takes into account the assumed period of use of the candidate battery may be calculated from the usage history of the installed battery, or may be the assumed amount of deterioration that is described above. In the present disclosure, the assumed period of use may be a predetermined value that is set in advance, a scheduled period of use of the candidate battery, a user-requested period such as how long the user desires to use the battery in the future and so forth, or a period taking into consideration a replacement cost and so forth of the battery that is requested by the user.

Current Rate History

The rate distribution of the current rates at which the installed battery has been used may be calculated based on the current rate history extracted from the usage history of the installed battery. A predetermined current rate may be set from the rate distribution that is calculated. Also, the greatest current value may be calculated from the current rate history. In the present disclosure, the predetermined current rate varies depending on the battery usage environment of the user, the type of battery, the materials used in the battery and so forth, and accordingly can be set as appropriate.

Amount of Deterioration

The amount of deterioration of a battery may be calculated from each usage history of batteries such as the installed battery, the candidate battery, and so forth. The assumed amount of deterioration of a candidate battery may be calculated from the usage history of the installed battery. The amount of deterioration is defined as follows. The amount of deterioration is defined in the form of a resistance value of the battery ($m\Omega$), or a rate of rise in resistance (%) of the present resistance of the battery with the resistance value of the battery at the time of shipping as a reference. The capacity of the battery decreases in association with increase of the amount of deterioration of the battery.

Calculation Method of Amount of Deterioration

The method for calculating the amount of deterioration is as follows. The amount of deterioration at each temperature is calculated based on the deterioration rate at each temperature and each SOC (equipment left standing/equipment in operation), temperature history, SOC history, and electricity passage history. The electricity passage history is converted into total electricity passage time. The total amount of deterioration of the battery is calculated by adding up the amount of deterioration calculated at each temperature.

FIG. 2 is a graph showing a relation between temperature T and the deterioration rate of the battery. The deterioration rate can be obtained from the following Expression (1).

$$\text{Deterioration rate } [\%/\sqrt{h}] = \alpha \times \text{EXP} (\beta \times \text{temperature T}) \dots \text{Expression (1)}$$

Here, $\alpha$ (intercept) and $\beta$ (inclination) are calculated based on the deterioration rate for each temperature and each SOC. The deterioration rate may be obtained in advance as a deterioration rate data group, by testing or the like. Note that when the equipment is a vehicle, the term "equipment in operation" means when the vehicle is traveling. Accordingly, the equipment in operation is exemplified in FIG. 2 as "traveling".

FIG. 3 is a diagram showing an example of electricity passage time at each temperature at a predetermined SOC of the battery. FIG. 3 shows how long the battery was exposed at each temperature at a predetermined SOC. The amount of deterioration for a predetermined temperature $T_1$ and a predetermined $SOC_1$ can be calculated from the following Expression (2).

$$(\text{Deterioration rate of } T_{1\_SOC1})^2 \times (\text{time } h_1 \text{ exposed to } T_{1\_SOC1}) = (\text{amount of deterioration}$$

$$C_1 \text{ when exposed to } T_{1\_SOC1})^2 \dots \text{Expression (2)}$$

The amount of deterioration $C_1$ to $C_{xx}$ can be calculated for each temperature and each SOC by the above Expression (2). When the equipment is a vehicle, the amount of deterioration may be calculated for each of when the vehicle is left standing and when the vehicle is traveling. The total amount of deterioration can be calculated by the following Expression (3).

$$\text{Total amount of deterioration } C_{total} = \sqrt{\{(\text{amount of deterioration } C_1)^2 + (\text{amount of}}$$

$$\text{deterioration } C_2)^2 + ... (\text{amount of deterioration } C_{xx})^2\} ... \text{Expression (3)}$$

The total amount of deterioration $C_{total}$ is calculated by adding up the amounts of deterioration $C_1$ to $C_{xx}$ for each temperature and each SOC, and can be calculated by the above Expression (3).

Diagnosis of Deterioration of Candidate Battery

The amount of deterioration and capacity of candidate batteries (whether used or new) in a replacement candidate list may be diagnosed in advance. The candidate batteries may then be ranked based on the amount of deterioration and the capacity thereof. For example, the diagnosis information may be listed as shown in Table 1 below. The obtained diagnosis information may be information that is aggregated in a server, and a control unit described below may receive the diagnosis information. The control unit may use the received diagnosis information to select candidate batteries. The capacity of the candidate battery may be determined including the amount of deterioration of the candidate battery and the manufacturing variance of the candidate battery. In Table 1, an assumed greatest current rate (1) is a value calculated as follows. The greatest current value of the installed battery is calculated from the current rate history of the installed battery. The assumed greatest current rate (1) is calculated from the calculated greatest current value of the installed battery and the capacity of the candidate battery (capacity at the point in time of replacement). In Table 1, an assumed greatest current rate (2) is a value calculated from the greatest current value of the installed battery and the capacity of the candidate battery (capacity taking the assumed amount of deterioration after replacement into consideration). The capacity of this candidate battery is calculated based on the reduction in capacity of the candidate battery due to the amount of deterioration of the candidate battery, taking into account the assumed period of use of the candidate battery. The assumed greatest current rate (2) may be greater than the assumed greatest current rate (1), due to taking into account the reduced capacity of the candidate battery.

Selecting a Replacement Battery

In the battery management system, a replacement battery is selected from among a plurality of candidate batteries, to replace an installed battery that is installed in equipment. In the battery management system, a battery of which the assumed greatest current rate of the candidate battery that is calculated is no greater than a predetermined current rate, is selected from among the candidate batteries as the replacement battery. Having at least two candidate batteries is sufficient, with no upper limit in particular regarding the number thereof. When there is no battery that is no greater than the predetermined current rate, the settings of the predetermined current rate may be changed, or a battery having the assumed greatest current rate that is closest to the predetermined current rate may be selected. When there are two or more candidate batteries that are no greater than the predetermined current rate, the battery having the highest capacity of the two or more candidate batteries may be selected as the replacement battery.

Table 1

| Candidate Battery | Amount of Deterioration | Capacity | Rank | Assumed Greatest Current Rate (1) | Assumed Greatest Current Rate (2) |
|---|---|---|---|---|---|
| Battery 1 | Small | Small | C | 44C | 48C |
| Battery 2 | Great | Small | B | 40C | 44C |
| Battery 3 | Small | Great | A | 36C | 40C |

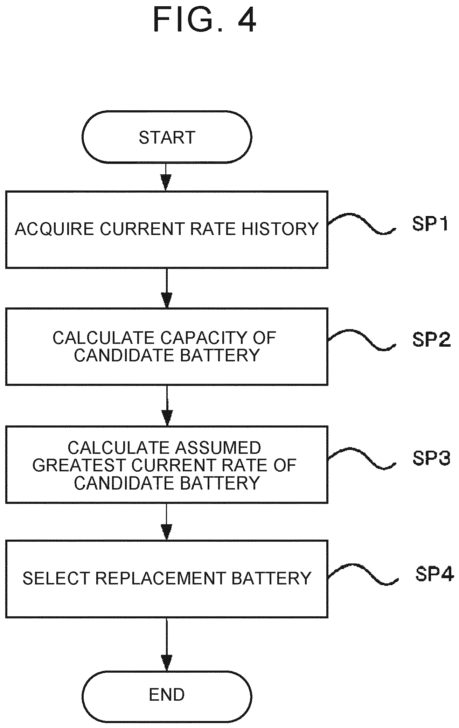

FIG. 4 is a flowchart showing an example of procedures of a selection method for a replacement battery, executed by the battery management system according to the present disclosure. SP1: The current load is analyzed based on the usage history of the installed battery of the user, the current rate history is acquired, and the predetermined current rate is set. SP2: The capacity of the candidate battery is calculated, taking into consideration the amount of deterioration of the candidate battery, based on the usage history of at least one battery of the installed battery and the candidate battery. SP3: The assumed greatest current rate of the candidate battery is calculated, taking into consideration the current rate history of the installed battery, the capacity of the candidate battery taking into consideration the amount of deterioration of the candidate battery, and the assumed period of use of the candidate battery as necessary. Here, the candidate batteries that are candidates for replacement may be ranked and listed. SP4: Of the candidate batteries, the battery of which the assumed greatest current rate no greater than the predetermined current rate is selected as the replacement battery. As shown in Table 1, when the predetermined current rate is 40C, for example, selecting candidate batteries based only on the assumed greatest current rate (1) may lead to misidentifying the optimal battery. Note that the current rate (current C rate) here is the magnitude of the current when charging and discharging to and from the battery. "1C" means the current value at which a battery in a fully-charged state (SOC 100%) is completely discharged (SOC 0%) in one hour. On the other hand, a more optimal battery can be selected by calculating and using the assumed greatest current rate (2).

In the present disclosure, examples of equipment include, but are not limited to, vehicles such as hybrid electric vehicles (HEVs), plug-in hybrid electric vehicles (PHEVs), battery electric vehicles (BEVs), gasoline-powered automobiles, diesel-powered automobiles, and so forth, moving bodies other than vehicles (e.g., trains, ships, airplanes), electric products such as information processing devices and so forth, and the like.

In the present disclosure, a battery may be a primary battery or a secondary battery. The battery may be an aqueous battery, a non-aqueous battery, an all-solid-state battery, or the like. An all-solid-state battery may have at least one unit cell made up of a positive electrode including a positive electrode current collector and a positive electrode layer, a solid electrolyte layer, and a negative electrode including a negative electrode current collector and a negative electrode layer. The materials used in the battery are not limited, and various types of materials can be used. The negative electrode active material may be lithium titanate (LTO). Examples of the lithium titanate include $Li_4Ti_5O_{12}$ and so forth.

The battery management system according to the present disclosure may include a detection unit, a control unit, and a computing unit. The detection unit may detect usage history of batteries, including installed batteries, candidate batteries, and so forth. The computing unit may calculate the rate distribution, the greatest current value, and so forth, from the current rate history of installed batteries. The computing unit may calculate the amount of deterioration of batteries, including installed batteries, candidate batteries, and so forth, based on the usage history. The computing unit may calculate the capacity of candidate batteries by taking the amount of deterioration of the candidate batteries into consideration. The computing unit may calculate the assumed greatest current rate of a candidate battery when used in equipment, from the current rate history of the installed battery, and the capacity of the candidate battery taking into consideration the amount of deterioration of the candidate battery. The control unit may select batteries of which the assumed greatest current rate of the candidate battery that is calculated is no greater than the predetermined current rate, as replacement batteries, from among the candidate batteries. The control unit may update the usage history of the battery based on the usage history of the battery detected by the detection unit. The control unit may prepare diagnosis information in advance, including the amount of deterioration of the candidate battery that is a replacement candidate, the capacity of the candidate battery taking into consideration the amount of deterioration of the candidate battery, and the assumed greatest current rate of the candidate battery.

The battery management system including the detection unit, the control unit, and the computing unit, physically includes, for example, an arithmetic processing unit such as a central processing unit (CPU), storage devices such as read-only memory (ROM) that stores control programs, control data, and so forth, to be processed by the CPU, and random-access memory (RAM) that is mainly used as various types of work areas for control processing, and an input/output interface.

**Claims**

1. A battery management system comprising an arithmetic processing unit for selecting a replacement battery from among a plurality of candidate batteries to replace an installed battery that is installed in equipment, the arithmetic processing unit configured to:

   calculate an assumed greatest current rate of each of the candidate batteries when used in the equipment, from current rate history of the installed battery and capacity of the candidate battery taking into consideration an amount of deterioration of the candidate battery; and
   select a battery of which the assumed greatest current rate that is calculated is no greater than a predetermined current rate, from among the candidate batteries as the replacement battery.

2. The battery management system according to claim 1, wherein the arithmetic processing unit is configured to calculate the assumed greatest current rate of each of the candidate batteries when used in the equipment, from the current rate history of the installed battery, the capacity of the candidate battery taking into consideration an amount of deterioration of the candidate battery calculated based on usage history of the installed battery, and an assumed period of use of the candidate battery.

# FIG. 1

# FIG. 2

# FIG. 3

# FIG. 4

```
        ┌─────────────┐
        │    START    │
        └──────┬──────┘
               │
               ▼
  ┌───────────────────────────┐
  │ ACQUIRE CURRENT RATE      │  ～ SP1
  │ HISTORY                   │
  └───────────┬───────────────┘
              │
              ▼
  ┌───────────────────────────┐
  │   CALCULATE CAPACITY OF   │  ～ SP2
  │    CANDIDATE BATTERY      │
  └───────────┬───────────────┘
              │
              ▼
  ┌───────────────────────────┐
  │   CALCULATE ASSUMED       │  ～ SP3
  │ GREATEST CURRENT RATE OF  │
  │    CANDIDATE BATTERY      │
  └───────────┬───────────────┘
              │
              ▼
  ┌───────────────────────────┐
  │ SELECT REPLACEMENT BATTERY│  ～ SP4
  └───────────┬───────────────┘
              │
              ▼
        ┌─────────────┐
        │     END     │
        └─────────────┘
```

Europäisches
Patentamt

European
Patent Office

Office européen
des brevets

# EUROPEAN SEARCH REPORT

**Application Number**

EP 23 15 1212

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 831 822 B2 (IGUCHI HIROKI [JP]; TOYOTA MOTOR CO LTD [JP]) 9 September 2014 (2014-09-09) * column 1, line 49 – column 3, line 53; claims 1-6 * | 1,2 | INV. H01M10/42 H01M10/48 |
| X | KR 2017 0067730 A (BOSCH GMBH ROBERT [DE]) 16 June 2017 (2017-06-16) * paragraphs [0007], [0011] – paragraph [0046] * | 1 | |
| A | JP 2018 147827 A (TOSHIBA CORP) 20 September 2018 (2018-09-20) * paragraphs [0011], [0127] – paragraph [0130] * | 1,2 | |
| A | WO 2015/001930 A1 (RESC LTD [JP]) 8 January 2015 (2015-01-08) * the whole document * | 1,2 | |

**TECHNICAL FIELDS SEARCHED (IPC)**

H01M

The present search report has been drawn up for all claims

| Place of search | Date of completion of the search | Examiner |
|---|---|---|
| Munich | 25 July 2023 | Topalov, Angel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 1212

This annex lists the patent family members relating to the patent documents cited in the above-mentioned European search report.
The members are as contained in the European Patent Office EDP file on
The European Patent Office is in no way liable for these particulars which are merely given for the purpose of information.

25-07-2023

| Patent document cited in search report | | Publication date | Patent family member(s) | | Publication date |
|---|---|---|---|---|---|
| US 8831822 | B2 | 09-09-2014 | CN | 103568862 A | 12-02-2014 |
| | | | JP | 5641024 B2 | 17-12-2014 |
| | | | JP | 2014035825 A | 24-02-2014 |
| | | | US | 2014046536 A1 | 13-02-2014 |
| KR 20170067730 | A | 16-06-2017 | CN | 107107768 A | 29-08-2017 |
| | | | DE | 102014220098 A1 | 07-04-2016 |
| | | | KR | 20170067730 A | 16-06-2017 |
| | | | WO | 2016050446 A1 | 07-04-2016 |
| JP 2018147827 | A | 20-09-2018 | CN | 108574317 A | 25-09-2018 |
| | | | EP | 3373020 A1 | 12-09-2018 |
| | | | JP | 6567582 B2 | 28-08-2019 |
| | | | JP | 2018147827 A | 20-09-2018 |
| | | | US | 2018261893 A1 | 13-09-2018 |
| WO 2015001930 | A1 | 08-01-2015 | CN | 105493378 A | 13-04-2016 |
| | | | CN | 108749624 A | 06-11-2018 |
| | | | CN | 108973744 A | 11-12-2018 |
| | | | CN | 114084032 A | 25-02-2022 |
| | | | JP | 5362930 B1 | 11-12-2013 |
| | | | JP | 6181482 B2 | 16-08-2017 |
| | | | JP | 6371450 B2 | 08-08-2018 |
| | | | JP | 6730643 B2 | 29-07-2020 |
| | | | JP | 2015015827 A | 22-01-2015 |
| | | | JP | 2015015875 A | 22-01-2015 |
| | | | JP | 2017225342 A | 21-12-2017 |
| | | | JP | 2019004693 A | 10-01-2019 |
| | | | TW | 201511986 A | 01-04-2015 |
| | | | WO | 2015001930 A1 | 08-01-2015 |

EPO FORM P0459

For more details about this annex : see Official Journal of the European Patent Office, No. 12/82

**EP 4 246 658 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016139572 A